# EUROPÄISCHE PATENTSCHRIFT

(11) **EP 0 757 764 B1**
(45) Veröffentlichungstag und Bekanntmachung des Hinweises auf die Patenterteilung: **24.09.1997**
(21) Anmeldenummer: 95915765.2
(22) Anmeldetag: 10.04.1995
(51) Int. Cl.: F16H 61/00

(54) **STEUERGERÄT FÜR EIN AUTOMATISCHES GETRIEBE**
CONTROL FOR AN AUTOMATIC GEARBOX
APPAREIL DE COMMANDE POUR BOITE DE VITESSES AUTOMATIQUE

(30) Priorität: 29.04.1994 DE 4415133
(43) Veröffentlichungstag der Anmeldung: 12.02.1997
(73) Patentinhaber: SIEMENS AKTIENGESELLSCHAFT, 80333 München (DE)
(72) Erfinder: ULM, Michael, D-93087 Alteglofsheim (DE)
(86) Internationale Anmeldenummer: DE9500489
(87) Internationale Veröffentlichungsnummer: WO9530102

(56) Entgegenhaltungen:
- EP-A- 0 105 219
- EP-A- 0 541 035
- DE-A- 4 232 205

## Beschreibung

Die Erfindung betrifft ein Steuergerät nach dem Oberbegriff von Anspruch 1. Ein derartiges Steuergerät dient zum Steuern eines automatischen Getriebes in einem Kraftfahrzeug. Ist dieses Getriebe ein Stufengetriebe, so wird durch das Steuergerät in Abhängigkeit von dem Fahrzustand und dem Fahrerwunsch der jeweils geeignetste Gang ausgewählt und eingelegt. Ist das Getriebe stufenlos, so legt das Steuergerät die jeweils günstigste Getriebeübersetzung fest.

Bei einem bekannten Steuergerät, mit dem die elektromagnetisch betätigten Hydraulikventile eines automatischen Getriebes gesteuert werden, sind die Ventil spulen in das Steuergerät integriert, indem sie in eine elastische Vergußmasse eingebettet sind und dadurch in ihrer Lage innerhalb des Steuergerätegehäuses fixiert sind (DE 42 32 205 Al). Durch die Nachgiebigkeit der Vergußmasse können Fertigungstoleranzen eines Ventilblocks, auf den das Steuergerät bei der Montage an dem Gehäuse des automatischen Getriebes aufgesteckt werden muß, ausgeglichen werden.

Das Steuergerät muß, um seine Aufgabe einwandfrei ausführen zu können, die Signale einer ganzen Reihe von Sensoren auswerten, wie z.B. von Sensoren für die Motordrehzahl, Motorlast usw. Bei der älteren EP-A-722394, veröffentlicht am 24/07/96, entsprechend WO-A- 9510427, veröffentlicht am 20/04/95, wird der Aufwand an Kabelverbindungen und Steckern, die üblicherweise nötig sind, um die Getriebesteuerung mit den verschiedenen Sensoren zu verbinden, dadurch verringert, daß die Sensorsignale drahtlos an die Getriebesteuerung übertragen werden.

Der Erfindung liegt die Aufgabe zugrunde, den Aufwand für die Kommunikation des Steuergeräts mit solchen Sensoren, die Meßgrößen in dem Getriebe selbst erfassen, weiter zu verringern.

Diese Aufgabe wird erfindungsgemäß durch das Steuergerät nach Anspruch 1 gelöst. Zweckmäßige Weiterbildungen der Erfindung sind in den Unteransprüchen niedergelegt.

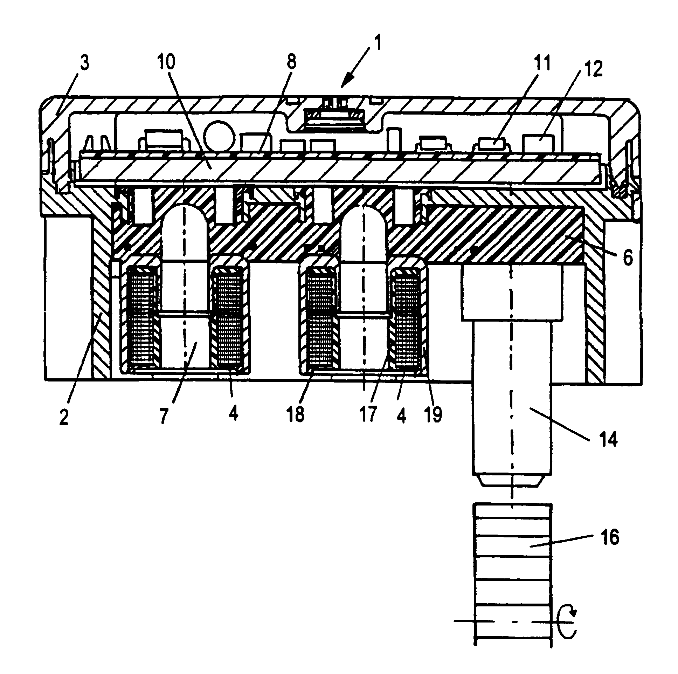

Ein Ausführungsbeispiel der Erfindung wird im folgenden anhand der einzigen Figur der Zeichnung erläutert.

Ein Steuergerät 1, weist ein Gehäuse auf, das aus einem Unterteil 2 und einem Deckel 3 besteht. Das Gehäuse-Unterteil 2 enthält eine Reihe von Ventilspulen 4, die in eine elastische Masse 6, z.B. eine Vergußmasse, eingebettet und damit in ihrer Lage fixiert sind. Das Unterteil 2 ist nach unten offen, es wird bei der Montage in eine Öffnung des hier nicht dargestellten Getriebegehäuses eingesteckt und an dem Getriebegehäuse befestigt. Dabei werden die Ventilspulen 4, die jeweils einen inneren Hohlraum 7 aufweisen, auf sog. Ventildome aufgeschoben, die aus einem Ventilblock herausragen, der in das Getriebe eingebaut ist und die Hydraulikventile enthält, die zum Betätigen der Reibelemente des Getriebes erforderlich sind. Das Getriebe und der Ventilblock sind hier nicht dargestellt, da sie für sich bekannt und nicht Bestandteil der Erfindung sind.

Das Gehäuse des Steuergeräts hält in einem durch den Deckel 3 abgeschlossenen Hohlraum eine als Schaltungsträger dienende Leiterplatte 8, die auf einem Kühlelement 10, z.B. in Form einer Aluminiumplatte, befestigt (z.B. aufgeklebt) ist. Auf der Leiterplatte 8 sind eine größere Anzahl von elektrischen und elektronischen Bauelementen 11, 12 montiert, die zusammen mit den sie verbindenden Leiterbahnen (in dieser Ansicht nicht sichtbar) die Schaltung des Steuergerätes bilden.

Ein Drehzahlsensor 14 ist ebenfalls in dem Unterteil 2 des Gehäuses angeordnet, und zwar in die elastische Masse 4 eingebettet und dadurch in seiner Lage fixiert. Er reicht bis in die Nähe eines als Polrad dienenden Zahnrades 16 oder eines sonstigen sich drehenden Bauteiles - z.B. einer Bremsbandtrommel des Getriebes -, das einen magnetischen Flußwechsel bewirkt und dessen Bewegung er durch Induktion oder durch den Halleffekt erfaßt. Die elektrischen Anschlußdrähte (in der Zeichnung nicht dargestellt) sind zu Kontaktierungsbohrungen der Leiterplatte 8 geführt und mit diesen verlötet. Dadurch entfällt die Notwendigkeit, elektrische Verbindungsleitungen aus dem Steuergerät herauszuführen, wodurch der Verkabelungsaufwand verringert und störanfällige Steckverbindungen vermieden werden.

Die Ventilspulen 4 bestehen in bekannter Weise aus einem hülsenformigen Spulenkörper 17 aus Kunststoff, einer darauf aufgebrachten elektrischen Wicklung 18 und einer metallischen Jochhülse 19. Sie werden von der Schaltung auf der Leiterplatte 8 gesteuert und betätigen wie erwähnt die Hydraulikventile in dem Getriebe.

## Patentansprüche

1. Steuergerät (1) für ein automatisches Getriebe in einem Kraftfahrzeug, mit einem Gehäuse (2, 3), in dem ein Träger (8) mit Schaltungsbestandteilen (11, 12) enthalten ist und in dem Ventilspulen (4) für elektromagnetische Hydraulikventile angeordnet und in eine elastische Masse (6) eingebettet sind,
**dadurch gekennzeichnet**,
- daß das Gehäuse (2, 3) ein offenes Unterteil (2) aufweist, und
- daß ein Drehzahlsensor (14), durch den eine Drehbewegung eines in dem Getriebegehäuse angeordneten rotierenden Teiles (16) erfaßt wird, im Inneren des offenen Unterteils (2) angeordnet ist und in die elastische Masse (6) eingebettet ist.

2. Steuergerät nach Anspruch 1, dadurch gekennzeichnet, daß der Drehzahlsensor (14) als induktiver Sensor ausgebildet ist.

3. Steuergerät nach Anspruch 1, dadurch gekennzeichnet, daß der Drehzahlsensor (14) als Halleffektsensor ausgebildet ist.

4. Steuergerät nach Anspruch 1, dadurch gekennzeichnet, daß der Drehzahlsensor (14) mit den Schaltungsbestandteilen (11, 12) auf dem Träger (8) elektrisch verbunden ist.

## Claims

1. Control unit (1) for an automatic transmission in a motor vehicle, with a housing (2, 3) which contains a carrier (8) with circuit components (11, 12) and in which valve coils (4) for electromagnetic hydraulic valves are arranged and embedded in a flexible compound (6),
characterized,
- in that the housing (2, 3) has an open bottom part (2) and
- in that a rotational-speed sensor (14), by means of which a rotary motion of a rotating part (16) arranged in the transmission housing is recorded, is arranged in the interior of the open bottom part (2) and embedded in the flexible compound (6).

2. Control unit according to Claim 1, characterized in that the rotational-speed sensor (14) is designed as an inductive sensor.

3. Control unit according to Claim 1, characterized in that the rotational-speed sensor (14) is designed as a Hall-effect sensor.

4. Control unit according to Claim 1, characterized in that the rotational-speed sensor (14) is connected electrically to the circuit components (11, 12) on the carrier (8).

## Revendications

1. Appareil de commande (1) pour boîte de vitesses automatique dans un véhicule à moteur, comportant un carter (2, 3), dans lequel est monté un support (8) avec des composants de circuit (11, 12) et dans lequel des bobines de vannes (4) pour des électrovannes hydrauliques sont placées et sont noyées dans une masse élastique (6),
caractérisé en ce que
- le carter (2, 3) comporte une partie inférieure (2)
et
- un capteur de vitesse (14), par lequel est détecté le mouvement de rotation d'une pièce tournante (16) placée dans le carter de la boîte de vitesses, est placé à l'intérieur de la partie inférieure ouverte (2) et noyé dans la masse élastique (6).

2. Appareil de commande selon la revendication 1, caractérisé en ce que le capteur de vitesse (14) est un capteur inductif.

3. Appareil de commande selon la revendication 1, caractérisé en ce que le capteur de vitesse (14) est un capteur à effet Hall.

4. Appareil de commande selon la revendication 1, caractérisé en ce que le capteur de vitesse (14) est relié électriquement aux composants de circuit (11, 12) sur le support (8).
